# EUROPEAN PATENT APPLICATION

(11) **EP 2 461 227 A2**
(43) Date of publication of application: **06.06.2012**
(21) Application number: 11191292.9
(22) Date of filing: 30.11.2011
(51) Int. Cl.: G06F 1/18

(54) **Electronic module and electronic device**

(30) Priority: 03.12.2010 US 419249 P
(71) Applicant: ASUSTeK Computer Inc., Taipei City 112 (TW)
(72) Inventor: Hu, Angus, Taipei (TW); Chiu, Hui-Wen, Taipei (TW); Lin, San-Feng, Taipei (TW)
(74) Representative: Becker Kurig Straus

(57) **Abstract**

An electronic device includes a motherboard, a connector, a expansion card and a housing. The motherboard includes an opening. The connector is disposed at the motherboard and at one side of the opening. The expansion card is inserted to the connector in order to be placed in the opening and coplanar with the motherboard. The motherboard, the connector and the expansion card are in the housing.

## Description

### BACKGROUND OF THE INVENTION

### Field of the Invention

The invention relates to an electronic module and, more particularly, to a structure improvement of the electronic module in an electronic device.

### Description of the Related Art

Various electronic products with different functions come on the market, and they are widely used in daily life and work. Electronic products, such as a desktop computer, a notebook and a tablet personal computer (PC), are usually used to deal with communication, schedule management or text processing. Benefit from the development of semiconductor elements and display technology, the electronic products become lighter, thinner, multi-functional and portable.

In a conventional computer, a display card or a memory card is assembled (stacked) with a motherboard with the non-coplanar way, but the structure cannot meet the requirement of lighter and thinner.

### BRIEF SUMMARY OF THE INVENTION

An electronic module having a motherboard, a connector and an expansion card is disclosed. The motherboard includes an opening. The connector is disposed at the motherboard and at one side of the opening. The expansion card is inserted to the connector at one side of the opening and coplanar with the motherboard.

An electronic device having an electronic module is disclosed, the electronic device having a motherboard, a connector, an expansion card and a housing. The motherboard includes an opening. The connector is disposed at the motherboard and at one side of the opening. The expansion card is inserted to the connector in order to be placed in the opening and coplanar with the motherboard. The motherboard, the connector and the expansion card are disposed in the housing.

These and other features, aspects and advantages of the present invention will become better understood with regard to the following description, appended claims, and accompanying drawings.

### BRIEF DESCRIPTION OF THE DRAWINGS

FIG. 1A is a schematic diagram showing partial of an electronic device in an embodiment;

FIG. 1B is a partial enlarged view showing the electronic module and electronic device in FIG. 1A;

FIG. 2A and FIG. 2B are schematic diagrams showing a part of components of the electronic module and electronic device in FIG. 1A;

FIG. 3 is a side view showing a partial structure of the electronic module and electronic device in FIG. 1A; and

FIG. 4A to FIG. 4D are schematic diagrams showing electronic devices in embodiments.

### DETAILED DESCRIPTION OF THE EMBODIMENTS

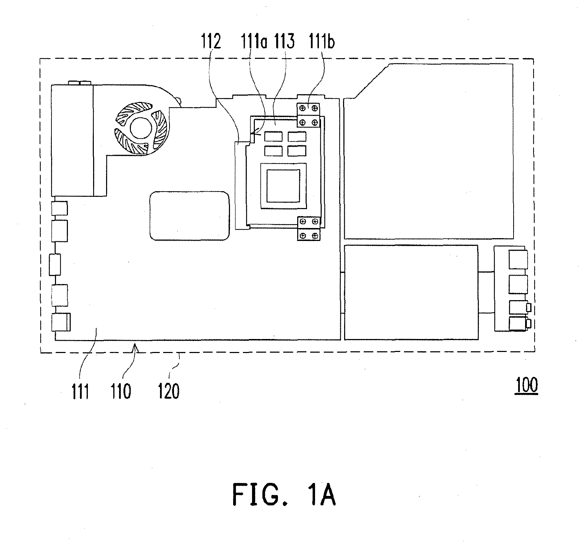

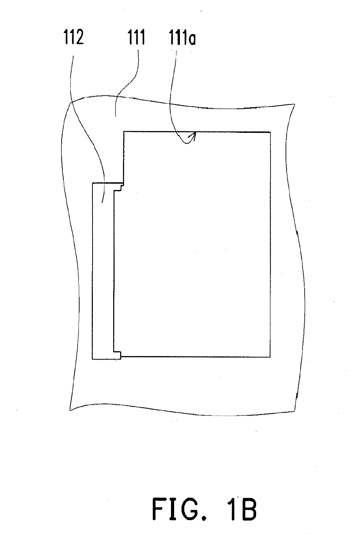

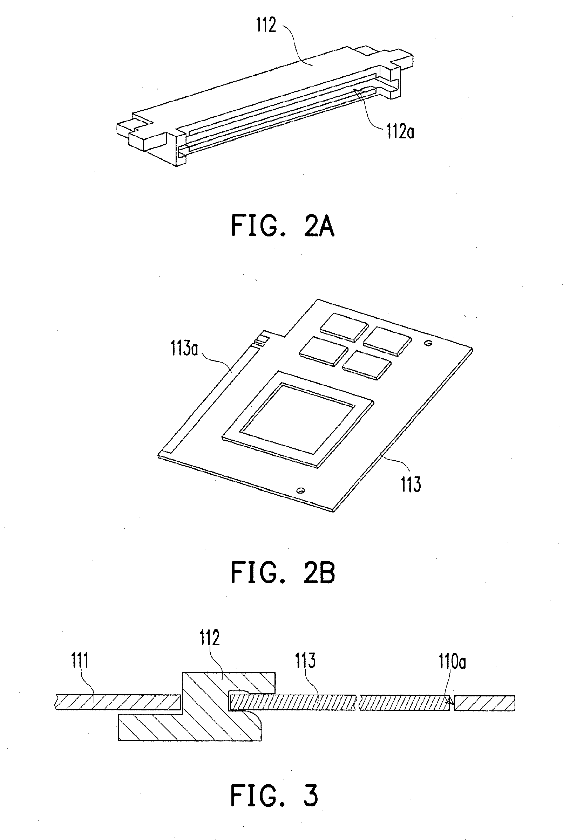

FIG. 1A is a schematic diagram showing partial of an electronic device in an embodiment. FIG. 1B is a partial enlarged view showing the electronic module and electronic device in FIG. 1A. FIG. 2A and FIG. 2B are schematic diagrams showing a part of components of the electronic module and electronic device in FIG. 1A. As showed in Figures, an electronic device 100 includes an electronic module 110 and a housing 120 for accommodating the electronic module 110. The electronic module 110 includes a motherboard 111, a connector 112 and an expansion card 113.

The motherboard 111 includes an opening 111 which is not disposed at the edge of the motherboard 111, and the outline of the opening 111 forms a closed area, as shown in FIG. 1B. The connector 112 is disposed at the motherboard 111 and at one side of the opening 111 a. The opening 111 also may be formed at any position of the motherboard 111 by demand.

FIG. 3 is a side view showing a partial structure of the electronic device in FIG. 1A. The outline of the opening 111a at the motherboard 111 matches with the outline of the expansion card 113. In other words, after assembly, the expansion card 113 is placed in the opening 111a and coplanar with the motherboard 111. That is, the circuit board of the expansion card 113 and the circuit board of the motherboard 111 are at one plane.

Consequently, comparing to the thickness of conventional stacked structure, the thickness of the electronic module and electronic device is reduced. Since the expansion card 113 and the motherboard 111 are at one plane, the manufacturing process for fixing the expansion card 113 and the motherboard 111 are much easier.

The connection of the motherboard 111, the connector 112 and the expansion card 113 is further illustrated below. The connector 112 may be an inclined insert connector or a flat insert connector. The connector 112 is disposed at one side of the opening 111a of the motherboard 111, and the connector 112 includes a slot 112a for the expansion card 113 to inclined or flat inserting in. One end of the expansion card 113 has an inserting part 113a for inclined inserting or flat inserting to the slot 112a of the connector 112.

The user may insert the inserting part 113a of the expansion card 113 to the slot 112a of the connector 112 inclinedly or flatly. After insert in, the expansion card 113 is placed in the opening 111a of the motherboard 111 and coplanar with the motherboard 111.

After the expansion card 113 is placed in the opening 111a, the fixing method of the expansion card 113 and the motherboard 111 is further illustrated. In an embodiment, the motherboard 111 at least includes one fastener 111b to fix the insert-in expansion card 113 into the opening 111a. The fastener 111b may include fixing sheets and multiple screws for locking the fixing sheets to the motherboard 111 and the expansion card 113.

In another embodiment, the connector 112 may at least include a fastener to fix the expansion card 113 into the opening 111a. For example, the fastener may be a latch structure of a card connector.

The motherboard 111 of one specification may match with the expansion card 113 with different functions to meet various requirements, reduce manufacture cost, and decrease the thickness of the electronic device and electronic module. Moreover, the expansion card 113 with different functions, such as a display card or a memory card, may be selected according to personal preference.

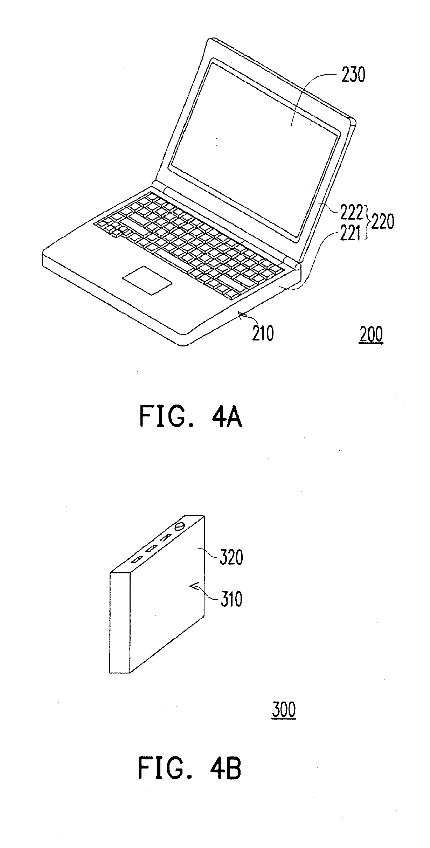

FIG. 4A to FIG. 4D are schematic diagrams showing electronic devices in embodiments. As shown in FIG. 4A, the electronic device 210 may be a notebook 200. The notebook 200 having a housing 220. The inside of the notebook 200 having an electronic module 110 as showed in FIG. 1A, and the housing 220 accommodates the electronic module 110. The notebook 200 further includes a display 230. The display 230 is disposed at the housing 220 and electrically connected to the electronic device 210.

The housing 220 of the electronic device 210 (the notebook computer 200) includes a bottom housing 221 and an upper housing 222. The bottom housing 221 is pivotally connected to the upper housing 222, the bottom housing 221 accommodates the notebook 200, and the display 230 is disposed at the upper housing 222. In the embodiment, the bottom housing 221 is a host part of the notebook computer, and the upper housing 222 is a display part of the notebook computer.

As shown in FIG. 4B, the electronic device 310 may be a mini-computer system 300. The inside of the mini-computer system 300 having the electronic module 110, as shown in FIG. 1A, and the housing 320 accommodates the electronic module 110. An external independent display (not shown) may be connected with the mini-computer 300 as an image human-machine interface (HMI).

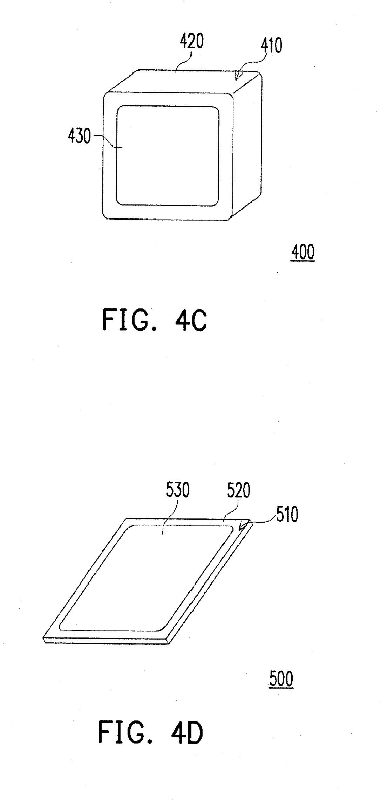

As shown in FIG. 4C, the electronic device 410 may be a table PC 400. The inside of the table PC 400 having an electronic module 110, as shown in in FIG. 1A, and the housing 420 accommodates the electronic module110. Moreover, the table pc 400 further includes a display 430 disposed at the housing 420.

As shown in FIG. 4D, the electronic device 510 may be a tablet PC 500 is disclosed. The tablet PC 500having an electronic module 110, as shown in FIG. 1A and a housing 520 and the housing 520 accommodates the electronic device 510. Moreover, the tablet PC 500 further includes a display 530 disposed at the housing 520.

In sum, since the expansion card is disposed at and coplanar with the motherboard, the electronic module and the electronic device can be thinner. Moreover, a multi-function electronic device can be modularized, and thus the expansion cards with different functions can be used in a motherboard, which meets various requirements of the users in buying or updating.

Although the present invention has been described in considerable detail with reference to certain preferred embodiments thereof, the disclosure is not for limiting the scope. Persons having ordinary skill in the art may make various modifications and changes without departing from the scope. Therefore, the scope of the appended claims should not be limited to the description of the preferred embodiments described above.

## Claims

1. An electronic module (100) comprising:
a motherboard (111) including an opening (111a);
a connector (112) disposed at one side of the opening (111a) on the motherboard (111); and
a expansion card (113) inserted to the connector (112) to be placed in the opening (111a) and coplanar with the motherboard (111).

2. The electronic module according to claim 1, wherein an outline of the opening (111a) matches with an outline of the expansion card (113).

3. The electronic module according to claim 1, wherein the expansion card (113) is a display card or a memory card.

4. The electronic module according to claim 1, wherein the connector (112) is an inclined insert connector or a flat insert connector.

5. The electronic module according to claim 1, wherein the electronic module (100) further includes a fastener (111b) to fix the expansion card (113) into the opening (111a).

6. An electronic device (100), comprising:
a motherboard (111) including an opening (111a);
a connector (112) disposed at the motherboard (111) and at one side of the opening (111a);
a expansion card (113) inserted to the connector (112) to be placed in the opening (111a) and coplanar with the motherboard (111); and
a housing (120) accommodating the motherboard (111), the connector (112) and the expansion card (113).

7. The electronic device according to claim 6, wherein the electronic device (200) further includes a display (230).

8. The electronic device according to claim 6, wherein an outline of the opening (111a) matches with an outline of the expansion card (113).

9. The electronic device according to claim 6, wherein the expansion card (113) is a display card or a memory card.

10. The electronic device according to claim 6, wherein the connector (112) is an inclined insert connector or a flat insert connector.

11. The electronic device according to claim 6, wherein the electronic device (100) further includes a fastener (111b) to fix the expansion card (113) into the opening (111a).
